# EUROPEAN PATENT SPECIFICATION

(11) **EP 3 882 378 B1**
(45) Date of publication and mention of the grant of the patent: **17.07.2024**
(21) Application number: 21162645.2
(22) Date of filing: 15.03.2021
(51) Int. Cl.: H05K 3/38, C25D 3/56, C25D 1/04, C25D 3/38, C25D 7/06, C25D 11/38, H05K 3/02

(54) **SURFACE-TREATED COPPER FOIL FOR HIGH-FREQUENCY CIRCUIT AND METHOD FOR PRODUCING THE SAME**
OBERFLÄCHENBEHANDELTE KUPFERFOLIE FÜR EINE HOCHFREQUENZSCHALTUNG UND VERFAHREN ZU DEREN HERSTELLUNG
FEUILLE DE CUIVRE TRAITÉE EN SURFACE POUR CIRCUIT HAUTE FRÉQUENCE ET SON PROCÉDÉ DE PRODUCTION

(30) Priority: 18.03.2020 LU 101698
(43) Date of publication of application: 22.09.2021
(73) Proprietor: Circuit Foil Luxembourg, 9559 Wiltz (LU)
(72) Inventor: MICHEZ, Roman, L-9559 Wiltz (LU); DEVAHIF, Thomas, L-9559 Wiltz (LU); KAIDI, Zainhia, L-9559 Wiltz (LU); STREEL, Michel, L-9559 Wiltz (LU)
(74) Representative: Office Freylinger

(56) References cited:
- KR-A- 20090 081 897
- US-A1- 2018 160 529
- US-A1- 2018 288 867
- US-A1- 2018 288 881
- KRISHNAN RAJESHWAR ET AL: "Review-Copper Oxide-Based Ternary and Quaternary Oxides: Where Solid-State Chemistry Meets Photoelectrochemistry", JOURNAL OF THE ELECTROCHEMICAL SOCIETY, vol. 165, no. 4, 1 January 2018 (2018-01-01), pages H3192 - H3206, XP055753500, ISSN: 0013-4651, DOI: 10.1149/2.0271804jes

## Description

### Technical Field

The present invention relates to a surface-treated copper foil for a high-frequency circuit, and more particularly relates to a surface-treated copper foil, which is excellent in adhesiveness with an insulating substrate for a high-frequency circuit and also excellent in transmission characteristics in a high-frequency region.

### Background Art

Growing recently are such needs that large volumes of data be processed at higher speed along with the popularization of information terminals like smartphones and mobile PCs as well as SNS, i.e. social networking service and video sites. Such being the case, with respect to mobile communication apparatuses including typically mobile phones and electronics including computers which employ networks to process data, signals of higher frequency in order to conduct transmission processing of a large capacity of information are remarkable. Nowadays, developments using signals of the GHz order have been rapidly progressing, so that printed wiring boards for a high-frequency circuit capable of coping with such high-speed signals have been demanded.

In constructing the printed wiring board for a high-frequency circuit, a copper clad laminate to which a copper foil is adhered is used for an insulating substrate with dielectric loss in high-frequency signals taken into consideration. To name but a few insulating substrates for high-frequency circuits, such resins containing thermosetting polyphenylether, modified polyphenylether, and the like are used. Such a copper clad laminate having an insulating material to which a copper foil is bonded requires a very high temperature press-working, and thereby It is known that blisters (i.e. swollenness) occur during high-temperature pressing. That being the case, in order to suppress occurrence of such blisters, there proposed various surface-treated copper foils for the purpose of improving adhesiveness between an insulating substrate and a copper foil (e.g. Patent Documents 1 and 2).

### Related Art Document

### Patent Documents

[Patent Document 1] JP2017-122274 A
[Patent Document 2] JP 5764700 B
[Patent Document 3] JP 6294862 B

Insulating substrates for high-frequency circuits are under development in an active manner, and as affairs stand now, every time new insulating substrates have been developed, such surface-treated copper foils as capable of satisfying fully the adhesiveness with respect to the insulating substrates are much more demanded.

### Summary of the Invention

### Problems to be Solved by the Invention

It is an object of the present invention to provide a surface-treated copper foil, which is excellent in adhesiveness with an insulating substrate for a high-frequency circuit, and particularly is capable of producing a copper clad laminate where occurrence of blisters are suppressed even when a thermal load due to high temperature press-working is applied.

### Means for Solving the Problems

The present invention is characterized by a method for producing a surface-treated copper foil is characterized by: employing a plating bath for quaternary metal film including 0.2 to 6.0 g/L of chromium, 1.0 to 9.0 g/L of molybdenum, 1.0 to 8.0 g/L of zinc and 1.0 to 7.0 g/L of nickel in terms of metal; and forming a heat resisting treated layer on the surface of the copper foil having a thickness of 35 µm or less under the conditions of a pH of 3 to 4 and a current density of 1.0 to 5.0 A/dm².

The surface-treated copper foil for a high-frequency circuit having a heat resisting treated layer formed on a copper foil of 35 µm or less in thickness, in which the heat resisting treated layer is a film including a quaternary metal oxide of chromium, molybdenum, zinc, and nickel and a composite thereof.

The heat resisting treated layer of the present disclosure has a coating weight of 0.1 to18 mg/m² of chromium, 10 to 45 mg/m² of molybdenum, 30 to 70 mg/m² of zinc, and 10 to 30 mg/m² of nickel in terms of metal.

### Advantageous Effects of the Invention

The surface-treated copper foil of the present disclosure has excellent adhesiveness to an insulating substrate for high-frequency circuits, so that even when the copper foil is subjected to high temperature press-working, particularly is subjected to a thermal load of 290°C for an hour, a copper clad laminate where occurrence of blisters is suppressed can be produced. Then, the surface-treated copper foil of the present disclosure can be realized with the use of a plating bath for a quaternary metal film containing chromium, molybdenum, zinc, and nickel having a specific concentration to form a heat resisting treated layer, which is a film including a quaternary metal oxide and a compound thereof, and thereby efficient producing is possible.

### Brief Description of the Drawing

FIG. 1 is a photograph showing a comparison for assessing occurrence of blisters, and
FIG. 2 shows a graph in which plotted is a result of an XPS analysis conducted on the surface-treated copper foil of the present example.

### Embodiment for Carrying Out the Invention

The present invention will be described in details hereinafter. In the present invention, there is formed on a surface of a copper foil having a thickness of 35µm or less a heat resisting treated layer, which is a film including a quaternary metal oxide of chromium, molybdenum, zinc, and nickel and a compound thereof. That being the case, even when the surface-treated copper foil is adhered to an insulating substrate for high-frequency circuits, which substrate requires high temperature press-working, to form a copper clad laminate, and is subjected to a thermal treatment at 290°C for an hour, any blisters or bulges will not occur.

In the surface-treated copper foil, each of the coating weight of the quaternary metal film constituting the heat resisting treated layer is preferably 0.1 to 18 mg/m² of chromium, 10 to 45 mg/m² of molybdenum, 30 to 70 mg/m² of zinc, and 10 to 30 mg/ m² of nickel in terms of metal. If each coating weight is smaller than the lower limit of respective elements, blisters or bulges are likely to occur, and if each coating weight exceeds the upper limit of respective elements, the high-frequency property is likely to deteriorate.

The present heat resisting treated layer is formed of a film including a quaternary metal oxide of chromium, molybdenum, zinc, and nickel and a compound thereof. Mixed oxides of the four kinds of metals raise the melting point of the heat resisting treated layer itself. Further, being made of a quaternary metal oxide and a compound thereof, the film is easily and strongly bonded to a chromate-treated layer and a silane coupling-treated layer.

For the surface-treated copper foil, an untreated electrolytic copper foil can be employed. A copper foil having a thickness of 35 µm or less is used. The surface roughness is preferably Rzjis 1.0 µm or less, and the tensile strength is preferably 300 to 400 N/mm² as an ordinary state.

In the surface-treated copper foil, it is preferable to previously deposit copper fine particles, conduct a copper seal plating to fix the copper fine particles to the copper foil surface, and to form a roughened layer on a surface of the untreated electrolytic copper foil, namely on a bonding surface to be bonded to the insulating substrate. Then, it is preferable to form a heat resisting treated layer, which is a film including quaternary metal oxides of chromium, molybdenum, zinc and nickel and a compound thereof on the surface of the roughened layer.

In forming the heat resisting treated layer of the surface-treated copper foil, a plating bath according to the method of the present invention is used for coating a quaternary alloy containing, in terms of metal, 0.2 to 6.0 g/L chromium, 1.0 to 9.0 g/L molybdenum, 1.0 to 8.0 g/L zinc, and 1.0 to 7.0 g/L nickel.

In this plating bath for coating a quaternary alloy, it is reasonable to put, for example, chromium into the plating bath in the form of CrOs, molybdenum in the form of Na₂MoO₄·2H₂O, zinc in the form of ZnSO₄·7H2O, and nickel in the form of NiSO₄·6H₂O. Further, in order to increase the conductivity of the plating bath, it is preferable to add sodium sulfate. The content of chloride in the plating bath is preferably 30 to 50 ppm. It is preferable to use a dilute solution of sodium hydroxide and sulfuric acid as the pH adjuster. It is preferable to use a dilute solution of sodium hydroxide and sulfuric acid as a pH adjuster.

Plating conditions for the plating bath for coating the quaternary alloy are preferably pH 3-4 and current density 0.5-5.0 A/dm₂.

In the surface-treated copper foil, it is preferable to form a heat resisting treated layer formed of a film of quaternary metals of chromium, molybdenum, zinc, and nickel, leave the film in the air for 10 to 50 seconds for oxidization, and subsequently form a chromate treated layer for the purpose of rust prevention. The coating weight of chromium in the chromate treated layer is preferably 3 to 5 mg/m² in terms of metal.

In the surface-treated copper foil, it is preferable to form a silane-coupling-agent-treated layer in order to improve the resistance to moisture-absorption deterioration when a printed wiring board is formed. Adoptable silane coupling agents include epoxy, amino, methacrylic, vinyl, mercapto, and acrylic, and especially epoxy, amino, and vinyl are more preferable.

### Description of Example

An example will be described below. The copper foil used in this example is an electrolytic copper foil produced to have a thickness of 18 µm with the use of a titanium electrolytic drum, a cathode and an insoluble anode, and a cupric sulfate electrolyte of a predetermined concentration and under predetermined electrolysis conditions. The surface roughness of the electrolytic copper foil was 1.0 µm Rzjis on the M surface side and 1.0 µm Rzjis on the S surface side. The terms M surface is a surface on the non-drum surface side of the electrolytic drum, and S surface is a surface on the drum surface side of the electrolytic drum. Note this electrolytic copper foil is also used in a later-described comparative example

A roughened layer was formed on the M surface of the electrolytic copper foil under the following conditions.

### Copper fine particle treatment:

| | |
|---|---|
| Copper sulfate | Cu 7.0 g/L (in terms of metal) |
| Sulfuric acid | 60 g/L |
| Bath temperature | 20°C |
| Current density | 23 A/dm² |
| Plating time | 2-3 sec. |

### Copper seal plating:

| | |
|---|---|
| Copper sulfate | Cu 7.0 g/L (in terms of metal) |
| Sulfuric acid | 60 g/L |
| Bath temperature | 50°C |
| Current density | 5 A/dm² |
| Plating time | 2-3 sec. |

After a roughened layer was formed, a heat resisting treated layer, which is a film including quaternary metal oxides of chromium, molybdenum, zinc, and nickel, and compound thereof was formed under the following conditions. The heat resisting treated layer was subjected to a below-mentioned quaternary metal film plating, left for 30 seconds in the air, and was formed.

Plating conditions for quaternary metal film:

### Plating bath composition

| | |
|---|---|
| CrO₃ | Cr 0.7 g/L (in terms of metal, hereinafter the same applies) |
| Na₂MoO₄·2H₂O | Mo 4.1 g/L |
| ZnSO₄·7H₂O | Zn 2.6 g/L |
| NiSO₄·2H₂O | Ni 2.0 g/L |
| Sodium sulfate | 15 g/L |
| Chloride content | 40 ppm |

### PH 3.7 (pH is adjusted with dilute sulfuric acid or dilute sodium hydroxide solution)

| | |
|---|---|
| Current density | 2.5 A/dm² |
| Plating time | 2 sec. |

After the heat resisting treated layer was formed, the coating weight of each metal of the heat resisting treated layer was examined and found as follows.

### Coating weight:

| | |
|---|---|
| Cr | 2.5 mg/m² (in terms of metal, hereinafter the same applies) |
| Mo | 38 mg/m² |
| Zn | 57 mg/m² |
| Ni | 25 mg/m² |

After the heat resisting treated layer was formed, a chromate-treated layer was formed under the following conditions.

### Chromate treatment conditions:

| | |
|---|---|
| CrOs | Cr 1.5 g/L (in terms of metal) |
| PH | 2.0 |
| Current density | 2A/dm² |
| Plating time | 2 sec. |

After the chromate-treated layer was formed, a silane-coupling-agent-treated layer was formed under the following conditions, and the surface-treated copper foil of the present example was produced.

| | |
|---|---|
| | Commercially available amino-based silane coupling agent Drying condition 85°C × 10 sec. |

### Comparative Example

As a comparative example, a surface-treated copper foil was prepared in which a roughened layer, a zinc-plated layer, a chromate-treated layer, and a silane-coupling-agent-treated layer were sequentially formed on the M surface of the electrolytic copper foil. Treatment conditions other than those for the galvanized layer were the same as those in the above example. The galvanized layer is subjected to the following conditions.

### Galvanizing conditions:

### Plating bath composition

| | |
|---|---|
| ZnSO₄·7H₂O | Zn 0.8 g/L (in terms of metal) |
| Current density | 2A/dm² |
| Plating time | 2 sec. |

The coating weight of each element in the surface-treated copper foil of this comparative example was examined and found as follows.

### Coating weight:

| | |
|---|---|
| Zn | 20 mg/m² |
| Cr | 4 mg/m² |

### <Evaluation of blister occurrence>

Two types of prepregs for high-frequency circuits were used to evaluate blister occurrence in high-temperature heat treatment on the surface-treated copper foils of Example and Comparative Example. MEGTRON 6 manufactured by Panasonic was used as a prepreg A, and DS-7409-DV manufactured by Doosan Corporation Electro-Materials, S. Korea was used as a prepreg B.

### Press conditions for each prepreg:

| Prepreg | A | B |
|---|---|---|
| Temperature conditions | 0-42 min (25-195°C) | 0∼40min (25-195°C) |
| | 42-162min (195°C) | 40-130min (195°C) |
| | 162-182min (195∼25°C) | 130-160min (195-25°C) |
| Pressure | 300N/cm² | 300N/cm² |

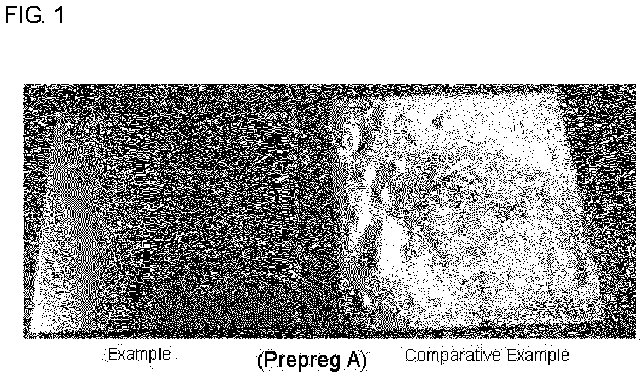

The copper-clad laminate obtained under the above press conditions was processed into a size of 5 cm × 5 cm, and subjected to a heat treatment in an oven at 290°C for 1 hour. For the purpose of reference, FIG. 1 shows a comparison photograph of an evaluation of blister occurrence (prepreg A). In FIG. 1, the left side is an example without blisters, and the right side is a comparative example in which blisters occurred.

In the surface-treated copper foil of the example, no blister occurrence was observed for the two types of prepregs. On the other hand, in the surface-treated copper foil of the comparative example, an occurrence of blisters was observed in both of the two types of prepregs. It was found from the results that any formation of blisters was successfully suppressed even when a surface-treated copper foil in which a heat resisting treated layer composed of a quaternary metal oxide of chromium, molybdenum, zinc, and nickel, and compound thereof had been formed on the surface of the copper foil was used to form a copper clad laminate in combination with a prepreg for a high-frequency circuit, and a high-temperature thermal load of 290°C for 1 hour was applied to the copper clad laminate.

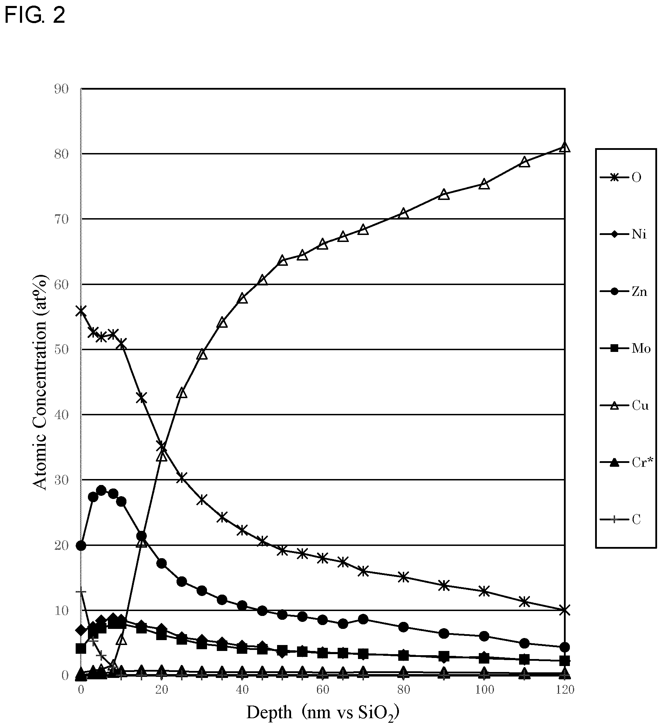

Next, result of an X-ray photoelectron spectroscopy analysis conducted on the surface-treated copper foil of the above example will be described. Used as an analysis target was a surface-treated copper foil on which a chromate treated layer had been formed under the same conditions as in the above example but silane coupling treatment was not performed. As an XPS analyzer, PHI Quantum 2000 (manufactured by ULVAC-PHI, Inc.) was used. The XPS analyzer has an X-ray source of Al-Kα of which beam diameter is 10 to 200 µm, and the surface of the surface-treated copper foil was subjected to sputter etching with the use of Ar ions accelerated to 2 KeV, which corresponds to a sputtering rate of 10 nm / min SiO₂) for analysis in a depth direction. The result is shown in FIG. 2.

FIG. 2 plots atomic concentrations of each element in the depth direction obtained by the XPS analyzer. The horizontal axis represents a depth, and the horizontal axis value corresponds to a depth where silicon oxide (SiO₂) is sputtered with Ar ions accelerated to 2 KeV. It was confirmed from the results shown in FIG. 2 that four kinds of metals such as chromium, molybdenum, zinc, and nickel are mixed. It was also confirmed that a slight amount of Cr is present in the depth direction of the film. It was yet further found from the binding energy peak with oxygen obtained by XPS analysis that each of the four metals was mixed as an oxide due to having been left in the air.

It is assumed from the results of the XPS analysis that the surface-treated copper foil of the present example realized such properties as adaptability for high-temperature heat treatment because a heat resisting treated layer as formed, which is a film composed of a quaternary metal oxide of chromium, molybdenum, zinc, and nickel and a compound thereof have a plurality of oxides mixed in the film, so that it will cause increase in the melting point and will help a chromate treated layer and a silane coupling treated layer to be formed after a heat resisting treatment is conducted bond strongly.

## Claims

1. A method for producing a surface-treated copper foil for a high-frequency circuit, comprising the steps of:
employing a plating bath for quaternary metal film, comprising 0.2 to 6.0 g/L of chromium, 1.0 to 9.0 g/L of molybdenum, 1.0 to 8.0 g/L of zinc, and 1.0 to 7.0 g/L of nickel in terms of metal;
subjecting a copper foil having a thickness of 35 µm or less to a surface treatment in said plating bath under conditions of a pH of 3 to 4 and a current density of 0.5 to 5.0 A/dm²; and
subsequently leaving the surface-treated copper foil in the air for 10 to 50 seconds.

## Patentansprüche

1. Verfahren zur Herstellung einer oberflächenbehandelten Kupferfolie für eine Hochfrequenz-Schaltung, das die folgenden Schritte umfasst:
Verwendung eines Beschichtungsbades für quaternäre Metallfilme, umfassend 0,2 bis 6,0 g/L Chrom, 1,0 bis 9,0 g/L Molybdän, 1,0 bis 8,0 g/L Zink und 1,0 bis 7,0 g/L Nickel in Bezug auf Metall;
Unterziehen einer Kupferfolie mit einer Dicke von 35 µm oder weniger einer Oberflächenbehandlung in dem Beschichtungsbad mit einem pH-Wert von 3 bis 4 und einer Stromdichte von 0,5 bis 5,0 A/dm², und
anschließend wird die oberflächenbehandelte Kupferfolie für 10 bis 50 Sekunden an der Luft gelassen.

## Revendications

1. Procédé de production d'une feuille de cuivre traitée en surface pour un circuit à haute fréquence, comprenant les étapes suivantes :
utiliser un bain d'électrolyse pour former un film de métal quaternaire, comprenant 0,2 à 6,0 g/L de chrome, 1,0 à 9,0 g/L de molybdène, 1,0 à 8,0 g/L de zinc et 1,0 à 7,0 g/L de nickel en termes de métal,
soumettre une feuille de cuivre ayant une épaisseur de 35 µm ou moins à un traitement de surface dans des conditions de pH de 3 à 4 et à une densité de courant de 0,5 à 5,0 A/dm², et
laisser ensuite la feuille de cuivre traitée en surface à l'air pendant 10 à 50 secondes.
